(19) Europäisches Patentamt
European Patent Office
Office européen des brevets

(11) **EP 4 373 244 B1**

(12) **EUROPEAN PATENT SPECIFICATION**

(45) Date of publication and mention
of the grant of the patent:
**25.06.2025 Bulletin 2025/26**

(21) Application number: **23199368.4**

(22) Date of filing: **25.09.2023**

(51) International Patent Classification (IPC):
**H10N 30/853** (2023.01)    **H10N 30/057** (2023.01)
**H10N 30/50** (2023.01)    **G01P 15/09** (2006.01)

(52) Cooperative Patent Classification (CPC):
**H10N 30/8542; G01P 15/0907; H10N 30/057;**
**H10N 30/505; H10N 30/8561**

(54) **PIEZOELECTRIC CERAMIC STACKED STRUCTURE AND METHOD OF MANUFACTURING THEREOF**

PIEZOELEKTRISCHE KERAMISCHE STAPELSTRUKTUR UND DEREN HERSTELLUNGSMETHODE

STRUCTURE EMPILÉE EN CÉRAMIQUE PIÉZOÉLECTRIQUE ET SON PROCÉDÉ DE FABRICATION

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **16.11.2022 KR 20220153850**

(43) Date of publication of application:
**22.05.2024 Bulletin 2024/21**

(73) Proprietor: **Korea Atomic Energy Research Institute**
**Daejeon 34057 (KR)**

(72) Inventors:
• **LEE, Min Ku**
**34071 Daejeon (KR)**
• **PARK, Kyu Hyun**
**34016 Daejeon (KR)**
• **LEE, Gyoung Ja**
**34140 Daejeon (KR)**
• **KIM, Byung Hoon**
**34008 Daejeon (KR)**
• **PARK, Jin Ju**
**34049 Daejeon (KR)**

(74) Representative: **Cabinet Beau de Loménie**
**103, rue de Grenelle**
**75340 Paris Cedex 07 (FR)**

(56) References cited:
**EP-A1- 3 413 362     US-A1- 2020 096 533**

• **ZUO ET AL: "Na0.5K0.5NbO3-BiFeO3 lead-free piezoelectric ceramics", JOURNAL OF PHYSICS AND CHEMISTRY OF SOLIDS, PERGAMON PRESS, LONDON, GB, vol. 69, no. 1, 20 December 2007 (2007-12-20), pages 230 - 235, XP022395292, ISSN: 0022-3697, DOI: 10.1016/J.JPCS.2007.08.066**
• **SONG AIZHEN ET AL: "Simultaneous Enhancement of Piezoelectricity and Temperature Stability in KNN-Based Lead-Free Ceramics Via Layered Distribution of Dopants", ADVANCED FUNCTIONAL MATERIALS, vol. 32, no. 34, 8 June 2022 (2022-06-08), DE, XP093138019, ISSN: 1616-301X, DOI: 10.1002/adfm.202204385**
• **LEE MIN-KU ET AL: "Piezoelectric voltage constant and sensitivity enhancements through phase boundary structure control of lead-free (K,Na)NbO3-based ceramics", JOURNAL OF THE EUROPEAN CERAMIC SOCIETY, ELSEVIER, AMSTERDAM, NL, vol. 42, no. 12, 14 May 2022 (2022-05-14), pages 4898 - 4906, XP087089427, ISSN: 0955-2219, [retrieved on 20220514], DOI: 10.1016/J.JEURCERAMSOC.2022.05.025**

**Description**

The present application claims priority to Korean Patent Application No. 10-2022-0153850, filed November 16, 2022.

BACKGROUND OF THE INVENTION

Field of the Invention

The present invention relates to a piezoelectric ceramic stacked structure and a method for manufacturing the piezoelectric ceramic stacked structure.

Description of the Related Art

Conventionally, various materials such as ceramics, single crystals, thick films and thin films have been developed as piezoelectric materials used in piezoelectric devices. Among them, piezoelectric ceramics made of $PbZrO_3$-$PbTiO_3$(PZT), a lead-containing perovskite ferroelectric, has excellent piezoelectric properties and has been widely used in various sensors, actuators, and transducers. Until now, piezoelectric materials containing lead (Pb), typically $Pb(Zr,Ti)O_3$(PZT), are widely used throughout the industry, such as fuel injectors, precision sensors, and actuators. However, lead has a low melting point and generates a significant amount of fumes at temperatures of 500 to 600 °C, acting on the nervous system through the human respiratory system. As a result, since 2002, the use of lead (Pb) has been severely restricted as the European Union (EU)'s Restriction of Hazardous Substance Directive (RoHS) has been strongly enforced around the world.

Accordingly, research on the development of lead-free piezoelectric materials to replace lead-containing piezoelectric materials has been actively conducted. Representative examples include $(K,Na)NbO_3$-based piezoelectric ceramics (KNN-based piezoelectric ceramics), $(Bi,Na)TiO_3$-based piezoelectric ceramics (BNT-based piezoelectric ceramics), $BaTiO_3$-based piezoelectric ceramics (BT-based piezoelectric ceramics), and $BiFeO_3$ - based piezoelectric ceramics (BFO-based piezoelectric ceramic). Among them, in the case of BNT-based piezoelectric ceramics, the polarization extinction temperature (Td) is as low as 200 °C, and in the case of BT-based piezoelectric ceramics, the Curie temperature (Tc) is less than 120 °C, which has the disadvantage of low operating temperature, making commercialization difficult. On the other hand, in the case of pure KNN and BFO piezoelectric ceramics, the Curie temperatures (Tc) are as high as 420°C and 820°C, and in the case of recently developed materials, excellent properties comparable to the piezoelectric properties ($d_{33}$) of the existing PZT have been recently reported, and thus, it is highly likely to be commercialized as a lead-free piezoelectric material.

However, KNN-based and BFO-based lead-free piezoelectric ceramics have limitations in their use at high temperatures because their piezoelectric properties change with temperature, such as decreasing or increasing piezoelectric properties when the temperature increases. This is because material structural properties such as phase structure and lattice structure of KNN-based and BFO-based piezoelectric ceramics do not remain constant and change when the temperature increases. Due to these problems, it is difficult to commercialize lead-free piezoelectric ceramics.

EP 3 413 362 discloses a piezoelectric element comprising a piezoelectric layer, provided between a first electrode and a second electrode, and formed of a perovskite type oxide including at least one selected from the group consisting of potassium, sodium, bismuth, and niobium; a first perovskite layer being provided between the piezoelectric layer and the first electrode, and a second perovskite layer being provided between the piezoelectric layer and the second electrode, wherein the first and the second perovskite layer preferably include at least one selected from the group consisting of bismuth and iron. US 2020/096533 discloses a piezoelectric ceramic structure, comprising at least one first piezoelectric layer and at least one second piezoelectric layer stacked on each other, wherein the first piezoelectric layer has a first structure in which a piezoelectric coefficient decreases as temperature increases, and the second piezoelectric layer has a second structure in which a piezoelectric coefficient increases as temperature increases, and an electrode layer is disposed between the first piezoelectric layer and the second piezoelectric layer, and disposed on exposed end surfaces of the first piezoelectric layer and the second piezoelectric layer. Zuo et al., Journal of Physics and Chemistry of Solids, 2008, vol. 69, pp. 230-235, disclose lead-free piezoelectric ceramics based on NKN ($Na_{0.3}K_{0.3}NbO_3$) with a small molar percentage of BF ($BiFeO_3$). Song Aizhen et al., Advance Functional Materials, 2022, 32, 2204385 disclose KNN-based stacked structures prepared based on nominal compositions ($Li_xNa_{0.52}K_{0.48-x}(Nb_{1-y}Sb_y)O_3$-$BaZrO_3$-$(Bi_{0.5}Na_{0.5})$ $HfO_3$-1wt%$MnO_2$ (with differing values of x and y giving layers $KNN_1$, $KNN_2$ and $KNN_3$). Lee Min-Ku et al., JOURNAL OF THE EUROPEAN CERAMIC SOCIETY, vol. 42, no. 12, 2022 pages 4898-4906, describe phase boundary structure control of piezoelectric materials by addition to $(K,Na)NbO_3$ ceramics of bismuth species such as $Bi_{0.3}(Na_{0.2}K_{0.1}Li_{0.7})_{0.3}ZrO_3$ (BNKLZ) and $BiScO_3$ (BS).

## SUMMARY OF THE INVENTION

The present invention provides a technique for solving the temperature instability of lead-free piezoelectric ceramics, and has an object to provide a piezoelectric ceramic stacked structure in which piezoelectric properties are maintained constant even at high temperatures by stacking KNN-based ceramics whose piezoelectric properties decrease as the temperature increases and BFO-based ceramics whose piezoelectric properties increase as the temperature increases.

As a result of repeated research, the inventors of the present invention have found that the above-described technical problem can be solved by a piezoelectric ceramic stacked structure including at least one first layer including a KNN-based ceramic; and at least one second layer including a BFO-based ceramic, wherein the first layer and the second layer are electrically connected in parallel, and wherein a ratio of a number ($n_1$) of the first layers stacked to a number ($n_2$) of the second layers stacked in the piezoelectric ceramic stacked structure satisfies Equation (1) below, and have come to complete the present invention.

$$0.8 \times |q|/|p| \leq n_1/n_2 \leq 1.2 \times |q|/|p| \ldots (1)$$

In Equation (1), $|p|$ represents an absolute value of a decrease rate (p) of a charge sensitivity according to a temperature of the first layer, and $|q|$ represents an absolute value of an increase rate (q) of a charge sensitivity according to a temperature of the second layer, and the decrease rate (p) of the charge sensitivity according to the temperature of the first layer and the increase rate (q) of the charge sensitivity according to the temperature of the second layer are slope values of a straight line obtained by approximating the charge sensitivity according to the temperature within a temperature range from room temperature (25 °C) to a Curie temperature (Tc) of the KNN-based ceramic by a method of least squares.

The piezoelectric ceramic stacked structure of the present invention may maintain constant piezoelectric and sensitivity properties at an initial room temperature within ±10 % up to about 300°C.

## BRIEF DESCRIPTION OF THE DRAWINGS

FIG. 1 is a piezoelectric accelerometer of Experimental Example 2.
FIG. 2 is a graph of charge sensitivity according to temperature in Example 1 and Comparative Examples 1 to 4.

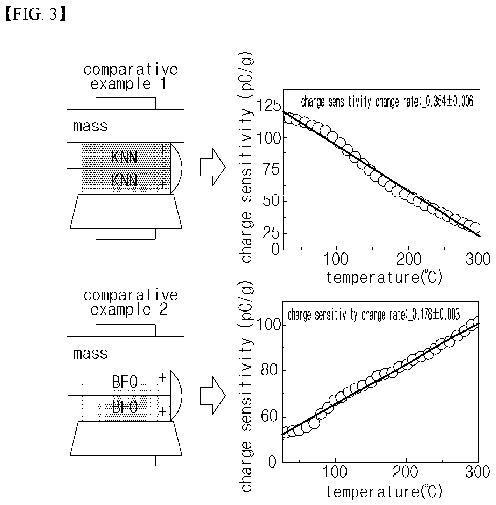

FIG. 3 is a graph of charge sensitivity according to temperature in Comparative Examples 1 and 2.

## DETAILED DESCRIPTION OF THE INVENTION

The present invention provides a piezoelectric ceramic stacked structure. Hereinafter, the piezoelectric ceramic stacked structure of the present invention will be described in detail.

The term "piezoelectric" in the present specification refers to an action of mutual conversion between mechanical energy and electrical energy through a medium of a piezoelectric body, and refers to an effect of generating electricity when pressure or vibration (mechanical energy) is applied. Indices indicating such piezoelectric performance include piezo-electric constants ($d_{33}$ and $d_{31}$), etc. In this case, the piezoelectric constant refers to the degree displaced when an electric field (V/m) is applied, or vice versa, and the larger the piezoelectric constant, the greater the advantage of enabling micro-displacement control.

In one embodiment of the present invention, a piezoelectric ceramic stacked structure includes at least one first layer including a KNN-based ceramic; and at least one second layer including a BFO-based ceramic, wherein the first layer and the second layer are electrically connected in parallel, and wherein a ratio of a number ($n_1$) of the first layers stacked to a number ($n_2$) of the second layers stacked in the piezoelectric ceramic stacked structure satisfies Equation (1) below.

$$0.8 \times |q|/|p| \leq n_1/n_2 \leq 1.2 \times |q|/|p| \ldots (1)$$

In Equation (1), $|p|$ represents an absolute value of a decrease rate (p) of a charge sensitivity according to a temperature of the first layer, and $|q|$ represents an absolute value of an increase rate (q) of a charge sensitivity according to a temperature of the second layer.

The decrease rate (p) of the charge sensitivity according to the temperature of the first layer and the increase rate (q) of the charge sensitivity according to the temperature of the second layer are slope values of a straight line obtained by approximating the charge sensitivity according to temperature within a temperature range from room temperature (25 °C) to a Curie temperature (Tc) of the KNN-based ceramic by a method of least squares.

In one embodiment of the present invention, the KNN-based ceramic may include a ceramic represented by $(K_3Na_{(1-b)}NbO_3$ (where $0<b<1$). KNN-based piezoelectric ceramics developed to date may have the Curie temperature of 200 to 500 °C. In addition, the KNN-based piezoelectric ceramic may simultaneously have excellent piezoelectric properties with a piezoelectric constant ($d_{33}$) of 150 to 650 pC/N. The KNN-based ceramic of the present invention is a lead-free piezoelectric ceramic that can replace the existing PZT piezoelectric ceramic, and thus the KNN-based ceramic can prevent environmental pollution caused by lead.

In one embodiment of the present invention, the KNN-based ceramic may further include at least one selected from the group consisting of Li, Sb, Ta, $CaZrO_3$, $SrZrO_3$, $BaZrO_3$, $CaTiO_3$, $SrTiO_3$, $BaTiO_3$, $Bi_{0.5}(Na_{c1}K_{c2}Li_{(1-c1-c2)})_{0.5}ZrO_3$ (where $0\leq c1\leq 1$, $0\leq c2\leq 1$, $0\leq c1+c2\leq 1$), $Bi_{0.3}(Na_{c1}K_{c2}Li_{(1-c1-c2)})_{0.5}TiO_3$ (where $0\leq c1\leq 1$, $0\leq c2\leq 1$, $0\leq c1+c2\leq 1$), $Bi_{0.3}Ag_{0.3}ZrO_3$, $Bi_{0.5}(Na_{c1}K_{c2}Li_{(1-c1-c2)})_{0.5}HfO_3$ (where $0\leq c1\leq 1$, $0\leq c2\leq 1$, $0\leq c1+c2\leq 1$), $Bi_{0.3}Ag_{0.3}HfO_3$, $BiScO_3$, $BiGaO_3$, and $BiFeO_3$, as a dopant.

In one embodiment of the present invention, the KNN-based ceramic may be represented by Formula 1 below.

$$\text{<Formula 1>} \qquad (1-a1-a2)(K_bNa_{(1-b)})NbO_3 - a1Bi_{0.5}(Na_{c1}K_{c2}Li_{(1-c1-c2)})_{0.5}ZrO_3 - a2BiScO_3$$

(where $0\leq a1\leq 1$, $0\leq a2\leq 1$, $0\leq a1+a2<1$, $0<b<1$, $0\leq c1\leq 1$, $0\leq c2\leq 1$, $0\leq c1+c2\leq 1$)

In Formula 1, a1 may be 0.01 to 0.05, 0.02 to 0.04, or 0.03. If $Bi_{0.5}(Na_{c1}K_{c2}Li_{(1-c1-c2)})_{0.5}ZrO_3$ ($0\leq c1\leq 1$, $0\leq c2\leq 1$, $0\leq c1+c2\leq 1$) is included in $(K_3Na_{(1-b)}NbO_3$ so that a1 satisfies the above range, the KNN-based ceramic may have excellent piezoelectric properties.

In Formula 1, a2 may be 0.005 to 0.015, 0.007 to 0.013, 0.009 to 0.011, or 0.01. If $BiScO_3$ is included in $(K_3Na_{(1-b)}NbO_3$ so that a2 satisfies the above range, the KNN-based ceramic may have excellent piezoelectric properties.

In Formula 1, c1+c2 may be 0.85 to 0.97, 0.87 to 0.95, 0.89 to 0.92, or 0.9. If c1+c2 satisfies the above range, the KNN-based ceramic may have excellent piezoelectric properties.

In one embodiment of the present invention, the KNN-based ceramic is composed of a mixed phase structure including at least one of orthorhombic crystal system, tetragonal crystal system, trigonal crystal system (also referred to as "rhombohedral crystal system"), and the like. The piezoelectric properties of the KNN-based ceramic of the present invention may decrease as the temperature increases regardless of the composition of the phase.

The BFO-based ceramic of the present invention may include $BiFeO_3$ as a basis, and is also referred to as a BFO-based piezoelectric ceramic. The BFO-based piezoelectric ceramics developed to date may have the Curie temperature of 400 to 830 °C. In addition, the BFO-based piezoelectric ceramic may have a remanent polarization of about 10 to 40 $\mu C/cm^2$. In addition, the BFO-based piezoelectric ceramic may have a piezoelectric constant ($d_{33}$) of 50 to 400 pC/N. The BFO-based piezoelectric ceramic of the present invention is a lead-free piezoelectric ceramic that can replace the existing PZT piezoelectric ceramic.

In one embodiment of the present invention, the BFO-based ceramic may be represented by Formula 2 below.

$$\text{<Formula 2>} \qquad (1-d)BiFeO_3 - dBaTiO_3$$

(where $0\leq d<1$).

In Formula 2, d may be 0.2 to 0.4, 0.25 to 0.35, or 0.3. If $BaTiO_3$ is included in $BiFeO_3$ so that d satisfies the above range, the BFO-based ceramic may have a high Curie temperature and a high piezoelectric constant.

The BFO-based ceramic represented by Formula 2 has a mixed phase structure including at least one of trigonal crystal system (also referred to as "rhombohedral crystal system"), pseudocubic crystal system, and the like. The piezoelectric properties of the BFO-based ceramic may increase as the temperature increases regardless of the composition of the phase.

In one embodiment of the present invention, the piezoelectric ceramic stacked structure may be lead-free. Since the piezoelectric ceramic stacked structure does not contain lead, environmental pollution due to lead may be prevented.

In one embodiment of the present invention, each thickness of the first layer including the KNN-based ceramic and the second layer including the BFO-based ceramic is independently 0.01 mm to 10 mm, 0.1 mm to 5 mm, or 0.5 mm to 2.5 mm, most preferably 1 mm. When the thickness of each of the first layer and the second layer satisfies the above range, each layer can effectively function as a piezoelectric ceramic, and it can be economical because less ceramic powder is used.

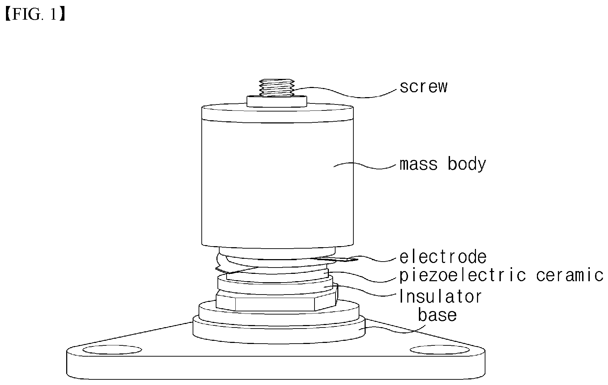

In one embodiment of the present invention, the temperature-dependent piezoelectric properties of the piezoelectric ceramic stacked structure of the present invention can be found by measuring the temperature-dependent charge sensitivity (Sq). The charge sensitivity according to temperature can be measured through a piezoelectric accelerometer as shown in FIG. 1. A piezoelectric accelerometer is a sensor that detects vibration, acceleration, and shock of an object by using a piezoelectric effect. The piezoelectric accelerometer of the present invention is a compression mode in which disc-shaped piezoelectric materials are arranged parallel to the vibration direction, that is, to detect acceleration in a direction parallel to the polarization direction. The basic structure of the piezoelectric accelerometer is shown in FIG. 1.

That is, as shown in FIG. 1, in the piezoelectric accelerometer of the present invention, an insulator may be stacked on a base, and then a piezoelectric ceramic stacked structure to be measured, an electrode, a mass body, and a screw may be sequentially stacked.

In one embodiment of the present invention, in the piezoelectric ceramic stacked structure, the first layer and the second layer may be alternately stacked. In this case, each layer must be stacked in a direction parallel to the vibration to realize the complex properties of the piezoelectric ceramic stacked structure. In addition, each polarized layer (specimen) must have a structure electrically connected in parallel.

By including the piezoelectric ceramic stacked structure of the present invention in the piezoelectric accelerometer, the charge sensitivity of the piezoelectric ceramic stacked structure can be measured. In addition, the piezoelectric accelerometer of the present invention can measure charge sensitivity even when the temperature changes. The charge sensitivity (Sq) obtained through the piezoelectric accelerometer has a relational expression as shown in Equation (2) below.

$$Sq = n \cdot m_s \cdot d_{33} \cdot g \ldots (2)$$

In Equation (2), n is the number of piezoelectric ceramics are stacked, $m_s$ is the mass of a mass body, $d_{33}$ is the static piezoelectric constant, and g is the gravitational acceleration.

Through the above equation, the (static) piezoelectric constant ($d_{33}$) can be obtained from the charge sensitivity (Sq). That is, the piezoelectric properties of the ceramic stacked structure can be obtained through the piezoelectric accelerometer.

According to the above method, the KNN-based ceramic layer is heated from room temperature to the Curie temperature, and the charge sensitivity at each temperature can be measured. The obtained temperature-dependent charge sensitivity data can be graph plotted with temperature as a variable, and the slope can be obtained through linear regression analysis using the method of least squares in the plotted data. The decrease rate (p) of the charge sensitivity according to the temperature of the first layer and the increase rate (q) of the charge sensitivity according to the temperature of the second layer can be obtained through the slope of the charge sensitivity graph according to the temperatures of the first layer and second layer obtained through the above method. Then, the ratio of the decrease rate (p) of the charge sensitivity according to the temperature of the first layer and the increase rate (q) of the charge sensitivity according to the temperature of the second layer can be obtained.

In one embodiment of the present invention, the first layers and the second layers are stacked such that the ratio of the number ($n_1$) of the first layers stacked and the number ($n_2$) of the second layers stacked in the piezoelectric ceramic stacked structure satisfies the following equation (1). In this case, since each layer is stacked so that the (+) pole and the (-) pole inside the layer face each other, each layer can be distinguished even if the same kind of layers are stacked.

$$0.8 \times |q|/|p| \leq n_1/n_2 \leq 1.2 \times |q|/|p| \ldots (1)$$

In one embodiment of the present invention, the difference between the number ($n_1$) of the first layers stacked and the number ($n_2$) of the second layers stacked to satisfy Equation (1) may be -1, 0, or 1. In this case, the first layers and the second layers may be alternately stacked. In the piezoelectric ceramic stacked structure of the present invention, when the first layers and the second layers are alternately stacked, the effect of maintaining constant piezoelectric properties even at high temperatures of the piezoelectric ceramic stacked structure may be excellent.

In one embodiment of the present invention, the absolute value (|p|) of the decrease rate (p) of the charge sensitivity according to the temperature of the first layer may be 0.3 to 0.4 pC/°Cg, 0.33 to 0.37 pC/°Cg, or 0.35 pC /°Cg.

In one embodiment of the present invention, the absolute value (|q|) of the increase rate (q) of the charge sensitivity according to the temperature of the second layer may be 0.15 to 0.2 pC/°Cg, 0.16 to 0.19 pC/°Cg, or 0.175 pC/°Cg.

In addition, the present invention provides a method for manufacturing the piezoelectric ceramic stacked structure. Hereinafter, in one embodiment of the present invention, a method for manufacturing a piezoelectric ceramic stacked structure will be described in detail for each step.

one embodiment of the present invention, the method for manufacturing a piezoelectric ceramic stacked structure includes forming a precursor powder of a KNN-based ceramic by weighing a KNN-based precursor mixture including sodium precursor powder, potassium precursor powder, and niobium precursor powder, and then mixing and calcining the mixture.

The step may be the step of solid-state synthesis of the precursor powder of the KNN-based ceramic having the composition of Formula 1 above.

In this case, the sodium precursor powder, potassium precursor powder, and niobium precursor powder may be, for example, ceramic powders of $Na_2CO_3$, $K_2CO_3$, and $Nb_2O_5$, but are not limited thereto, and other types of ceramic powder may be used for solid phase synthesis of the precursor powder of the KNN-based ceramic. For example, oxides, carbonates, oxalates, hydrogencarbonates, hydroxides, and the like containing the above elements may be weighed and mixed.

In addition, the method for manufacturing a piezoelectric ceramic stacked structure includes forming a precursor powder of a BFO-based ceramic by weighing a BFO-based precursor mixture including bismuth precursor powder, iron precursor powder, barium precursor powder, and titanium precursor powder, and then mixing and calcining the mixture.

The step may be the step of solid-phase synthesizing the precursor powder of the BFO-based ceramic having the composition of Formula 2 above.

In this case, the bismuth precursor powder, iron precursor powder, barium precursor powder, and titanium precursor powder may be ceramic powders of $Bi_2O_3$, $Fe_2O_3$, $BaCO_3$ and $TiO_2$, but are not limited thereto, and other types of ceramic powder may be used for solid-phase synthesis of the precursor powder of the BFO-based ceramic. For example, oxides, carbonates, oxalates, hydrogencarbonates, hydroxides and the like containing the above elements may be weighed and mixed.

In one embodiment of the present invention, the calcination may be performed at a temperature of about 700 or more and 1100 °C for 0.5 hours or more and 10 hours or less, but the present invention is not limited to this time range and may be arbitrarily shortened or extended as desired.

In one embodiment of the present invention, the method includes forming at least one first layer including the KNN-based ceramic represented by Formula 1 below by sintering the precursor powder of the KNN-based ceramic and forming at least one second layer including the BFO-based ceramic represented by Formula 2 below by sintering the precursor powder of the BFO-based ceramic.

In one embodiment of the present invention, the sintering temperature may be 1000 to 1250 °C, or 1100 to 1200 °C. If the sintering temperature is less than the above lower limit temperature, the raw material may not be sufficiently sintered and the ceramic may not have appropriate properties. In addition, if the sintering temperature exceeds the above upper limit temperature, a part of the element constituting the ceramic is precipitated and the piezoelectric properties are deteriorated.

In one embodiment of the present invention, the obtained precursor powder of the KNN-based ceramic and the precursor powder of the BFO-based ceramic may be pulverized with a ball mill and molded into a desired shape by adding a binder. The pulverizing and molding means known in the art of piezoelectric ceramics may be used for the pulverizing and molding.

In one embodiment of the present invention, the sintering time is 0.5 to 24 hours, 1 to 10 hours. If the sintering time is shorter than the lower limit of the sintering time, the molded body may not be completely sintered. In addition, if the sintering time is longer than the upper limit of the sintering time, some of the elements constituting the ceramic may be volatilized.

In one embodiment of the present invention, the method for manufacturing a piezoelectric ceramic stacked structure may further include a polarization treatment process after the sintering process. An electrode is formed on the ceramic obtained by the polarization treatment step, and polarization treatment is performed. By the polarization treatment, the directions of spontaneous polarization in the ceramic are aligned, and piezoelectric properties are developed. For the polarization treatment, a known polarization treatment generally used in the manufacturing of piezoelectric ceramics may be used. For example, the sintered body in which the electrode is formed is maintained at a temperature of not less than room temperature and not more than 200 °C or less in a silicon bath or the like, and a voltage of 1 kV/mm or more and about 6 kV/mm is applied to the sintered body. Accordingly, a piezoelectric ceramic having piezoelectric properties can be obtained.

In one embodiment of the present invention, in the method for manufacturing a piezoelectric ceramic stacked structure, a first layer including a disk-shaped KNN-based ceramic formed through the above process and a second layer including a BFO-based ceramic may be stacked. In this case, each layer must be stacked in a direction parallel to the vibration to realize the complex properties of the piezoelectric ceramic stacked structure. In addition, each polarized layer (specimen) must have a structure electrically connected in parallel.

Details of the piezoelectric ceramic stacked structure manufactured according to the method for manufacturing the piezoelectric ceramic stacked structure are the same as described above.

## [Examples]

Hereinafter, the present invention will be described in more detail through Manufacturing Examples and Examples. However, these Manufacturing Examples are only for helping the understanding of the present invention, and the scope of the present invention is not limited to these Manufacturing Examples and Examples in any sense.

Manufacturing Example

After quantifying the ceramic powders of $K_2CO_3$, $Na_2CO_3$, $Nb_2O_5$, $Sc_2O_3$, $TiO_2$, $Li_2CO_3$, $Bi_2O_3$, $BaCO_3$, $Fe_2O_3$ and $ZrO_2$ of the purity commonly used for industrial use to be $0.96(K,Na)NbO_3$-$0.03Bi_{0.5}(Na_{0.7}K_{0.2}Li_{0.1})_{0.5}ZrO_3$-$0.01BiScO_3$ and $0.70BiFeO_3$-$0.30BaTiO_3$, they were wet-mixed for 24 hours by a ball milling method to prepare a slurry. For the subsequent solid state reaction, the slurry was dried and then calcinated at 850 °C for 3 hours. A binder for molding was added to the calcined powder and sieved. The sieved powder was molded into a disk shape by applying a pressure of about 100 Mpa using a pressure molding machine, put in an electric furnace, and sintered at about 1100 °C for 3 hours to manufacture a disk with an outer diameter of 8.5 mm, an inner diameter of 3.9 mm, and a thickness of 1 mm. An electrode was formed on the piezoelectric ceramic obtained in the above process, and a polarization treatment was performed by maintaining a temperature of not less than room temperature and not more than 200 °C in a silicon bath and applying a voltage of about 3 kV/mm. Through the above-described method, a first layer including a KNN-based ceramic having a formula of $0.96(K,Na)NbO_3$-$0.03Bi_{0.5}(Na_{0.7}K_{0.2}Li_{0.1})_{0.5}ZrO_3$-$0.01BiScO_3$ and a second layer having a BFO-based ceramic having a formula of $0.70BiFeO_3$-$0.30BaTiO_3$ were obtained.

<Example 1>

According to the following Experimental Example, the sensitivity (piezoelectric property) according to the temperature of the KNN-based ceramic was measured, and the slope of the charge sensitivity according to the temperature of the first and second layers was derived using OriginPro 8G® (OriginLab Corporation, North Hampton, Massachusetts, USA) and Excel® (version 2007, Microsoft Corporation). The decrease rate (slope of the linear regression line, p) of the charge sensitivity according to the temperature of the first layer was $-0.354 \pm 0.006$ pC/°Cg, and the increase rate (slope of the linear regression line, q) of the charge sensitivity according to the temperature of the second layer was $0.178 \pm 0.003$ pC/°Cg. Accordingly, since $|q|/|p|$ was about 0.5028, a total of three layers were stacked by alternating one first layer between two second layers so that $n_1/n_2$, which was the ratio of the number ($n_1$) of the first layers stacked to the number ($n_2$) of the second layers stacked, was a value of 0.5, which lies between 0.4022, corresponding to $0.8 \times |q|/|p|$, and 0.6034, corresponding to $1.2 \times |q|/|p|$, that is, the ratio of 1: 2. In this case, each layer was stacked so that the same poles, that is, (+) poles and (-) poles face each other, or were stacked so as to be connected in parallel by connecting with electrodes.

<Comparative Example 1>

It was carried out in the same manner as in Example 1, except that a total of two layers were stacked only with the first layer.

<Comparative Example 2>

It was carried out in the same manner as in Example 1, except that a total of two layers were stacked only with the second layer.

<Comparative Example 3>

It was carried out in the same manner as in Example 1, except that a total of two layers were stacked so that the first layer and the second layer were stacked at a ratio of 1:1.

<Comparative Example 4>

It was carried out in the same manner as in Example 1, except that a total of three layers were stacked so that the first layer and the second layer were alternately stacked at a ratio of 2:1.

Experimental Examples

<Experimental Example 1: Measurement of electrical/piezoelectric properties>

The electrical/piezoelectric properties of the first layer and second layer at room temperature were measured and were shown in Table 1 below.

Remanent polarization and coercive field values were measured using a ferroelectric hysteresis curve measurement equipment (TF analyzer, aixACCT System) by connecting + poles and - poles to both ends of the first and second layer ceramic electrodes, putting them in a container of silicon oil for insulation, and then using a 10 Hz triangular wave in an electric field of 70 kV/cm at room temperature. Dielectric constant, Curie temperature and dielectric loss were measured using HP Impedance Analyzer HP4294A. The static piezoelectric constant ($d_{33}$) was measured by applying a force of 0.25 N using equipment (piezo-d33-meter, ZJ-6B, IACAS), and large-signal piezoelectric constant ($d_{33}^*$) was measured using equipment (TF analyzer, aixACCT System).

[Table 1]

| Material property | | KNN-based | BFO-based |
|---|---|---|---|
| Remanent polarization | $P_r(\mu C/cm^2)$ | 20.5 | 19.1 |
| Coercive Field | $E_C(kV/cm)$ | 13.8 | 26.2 |
| dielectric constant | $\varepsilon_r(-)$ | 1113 | 643 |
| dielectric loss | $\tan\delta(-)$ | 0.03 | 0.07 |
| Large-signal piezoelectric constant | $d_{33}^*(pm/V)$ | 441.1 | 278.0 |
| Static piezoelectric constant | $d_{33}(pC/N)$ | $310.0\pm4.8$ | $165.2\pm2.1$ |
| Curie temperature | $Tc(°C)$ | 330.9 | 505.0 |

<Experimental Example 2: Measurement of charge sensitivity according to temperature change>

In order to measure the change in piezoelectric properties according to temperature, charge sensitivity (Sq) was measured by a piezoelectric accelerometer sensor. As shown in FIG. 1, in the piezoelectric accelerometer, an insulator was stacked on a base, then a piezoelectric ceramic stacked structure to be measured, an electrode (Inconel 600), a mass body (Wc-Co alloy), and a screw (Inconel 600) were sequentially stacked.

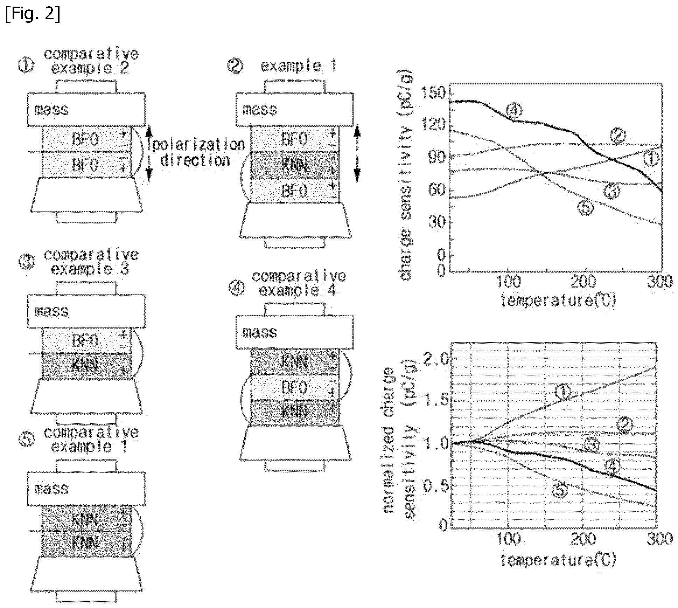

While replacing the piezoelectric ceramic stacked structures of Example 1 and Comparative Examples 1 to 4, the charge sensitivity curves according to temperature were obtained through the piezoelectric accelerometer and shown in FIG. 2.

According to FIG. 2, the piezoelectric ceramic stacked structure of Example 1 maintained a constant piezoelectric property at initial room temperature within ±10% up to about 300 °C or higher. Thus, it was confirmed that the piezoelectric ceramic stacked structure of Example 1 was superior in temperature stability to the piezoelectric ceramic stacked structures of Comparative Examples 1 to 4. It was confirmed that Comparative Examples 1 to 4, in which the material of the piezoelectric ceramic stacked structure was different or the stacked structure ratio was different, showed had different rates of change in sensitivity with temperature.

**Claims**

1. A piezoelectric ceramic stacked structure, comprising:

   at least one first layer comprising a K-Na-Nb, KNN-based ceramic; and
   at least one second layer comprising a Bi-Fe-O, BFO-based ceramic,
   wherein the first layer and the second layer are electrically connected in parallel, and
   wherein a ratio of a number $n_1$ of the first layers stacked to a number $n_2$ of the second layers stacked in the piezoelectric ceramic stacked structure satisfies Equation (1) below:

   $$0.8 \times |q|/|p| \leq n_1/n_2 \leq 1.2 \times |q|/|p| \ldots (1)$$

   wherein |p| represents an absolute value of a decrease rate p of a charge sensitivity according to a temperature of the first layer, |q| represents an absolute value of an increase rate q of a charge sensitivity according to a temperature of the second layer, and
   the decrease rate p of the charge sensitivity according to the temperature of the first layer and the increase rate q of the charge sensitivity according to the temperature of the second layer are slope values of a straight line obtained by approximating the charge sensitivity according to the temperature within a temperature range from room temperature, 25°C, to a Curie temperature, Tc, of the KNN-based ceramic by a method of least squares.

2. The piezoelectric ceramic stacked structure of claim 1, wherein the KNN-based ceramic comprises a ceramic

represented by $(K_3Na_{(1-b)}NbO_3$ where $0<b<1$.

3. The piezoelectric ceramic stacked structure of claim 2, wherein the KNN-based ceramic further comprises at least one selected from the group consisting of Li, Sb, Ta, $CaZrO_3$, $SrZrO_3$, $BaZrO_3$, $CaTiO_3$, $SrTiO_3$, $BaTiO_3$, $Bi_{0.5}(Na_{c1}K_{c2}Li_{(1-c1-c2)})_{0.5}ZrO_3$ where $0\leq c1\leq 1$ and $0\leq c2\leq 1$ and $0\leq c1+c2\leq 1$, $Bi_{0.5}(Na_{c1}K_{c2}Li_{(1-c1-c2)})_{0.5}TiO_3$ where $0\leq c1\leq 1$ and $0\leq c2\leq 1$ and $0\leq c1+c2\leq 1$, $Bi_{0.5}Ag_{0.5}ZrO_3$, $Bi_{0.3}(Na_{c1}K_{c2}Li_{(1-c1-c2)})_{0.5}HfO_3$ where $0\leq c1\leq 1$ and $0\leq c2\leq 1$ and $0\leq c1+c2\leq 1$, $Bi_{0.5}Ag_{0.5}HfO_3$, $BiScO_3$, $BiGaO_3$, and $BiFeO_3$, as a dopant.

4. The piezoelectric ceramic stacked structure of claim 1, wherein the KNN-based ceramic is represented by Formula 1 below:

<Formula 1>     $(1-a1-a2)(K_bNa_{(1-b)})NbO_3 - a1Bi_{0.5}(Na_{c1}K_{c2}Li_{(1-c1-c2)})_{0.5}ZrO_3 - a2BiScO_3$

where $0\leq a1\leq 1$, $0\leq a2\leq 1$, $0\leq a1+a2<1$, $0<b<1$ , $0\leq c1\leq 1$, $0\leq c2\leq 1$, $0\leq c1+c2\leq 1$.

5. The piezoelectric ceramic stacked structure of claim 1, wherein the BFO-based ceramic is represented by Formula 2 below:

<Formula 2>     $(1-d)BiFeO_3 - dBaTiO_3$

where $0\leq d<1$.

6. The piezoelectric ceramic stacked structure of claim 5, wherein d is greater than or equal to 0.2 and less than or equal to 0.4.

7. The piezoelectric ceramic stacked structure of claim 1, wherein the piezoelectric ceramic stacked structure is lead-free.

8. The piezoelectric ceramic stacked structure of claim 1, wherein the absolute value |p| of the decrease rate p of the charge sensitivity according to the temperature of the first layer is 0.3 to 0.4 pC/°Cg.

9. The piezoelectric ceramic stacked structure of claim 1, wherein the absolute value |q| of the increase rate q of the charge sensitivity according to the temperature of the second layer is 0.15 to 0.2 pC/°Cg.

10. A method for manufacturing a piezoelectric ceramic stacked structure, comprising:

forming a precursor powder of a K-Na-Nb, KNN-based ceramic by calcining a KNN-based precursor mixture comprising sodium precursor powder, potassium precursor powder, and niobium precursor powder;
forming a precursor powder of a Bi-Fe-O, BFO-based ceramic by calcining a BFO-based precursor mixture comprising bismuth precursor powder, iron precursor powder, barium precursor powder, and titanium precursor powder;
forming at least one first layer by sintering the precursor powder of the KNN-based ceramic;
forming at least one second layer by sintering the precursor powder of the BFO-based ceramic; and
forming a stacked structure including $n_1$ of the first layers and $n_2$ of the second layers
wherein a ratio of a number $n_1$ of the first layers stacked to a number $n_2$ of the second layers stacked satisfies Equation (1) below:

$$0.8 \times |q|/|p| \leq n_1/n_2 \leq 1.2 \times |q|/|p| \dots (1)$$

wherein |p| represents an absolute value of a decrease rate p of a charge sensitivity according to a temperature of the first layer, |q| represents an absolute value of an increase rate q of a charge sensitivity according to a temperature of the second layer, and
the decrease rate p of the charge sensitivity according to the temperature of the first layer and the increase rate q of the charge sensitivity according to the temperature of the second layer are slope values of a straight line obtained by approximating the charge sensitivity according to the temperature within a temperature range from room temperature , 25°C, to a Curie temperature, Tc, of the KNN-based ceramic by a method of least squares.

**11.** The method of claim 10, wherein the KNN-based ceramic comprises a ceramic represented by $(K_3Na_{(1-b)})NbO_3$ where $0<b<1$.

**12.** The method of claim 11, wherein the KNN-based ceramic further comprises at least one selected from the group consisting of Li, Sb, Ta, $CaZrO_3$, $SrZrO_3$, $BaZrO_3$, $CaTiO_3$, $SrTiO_3$, $BaTiO_3$, $Bi_{0.5}(Na_{c1}K_{c2}Li_{(1-c1-c2)})_{0.5}ZrO_3$ where $0 \leq c1 \leq 1$ and $0 \leq c2 \leq 1$ and $0 \leq c1+c2 \leq 1$, $Bi_{0.3}(Na_{c1}K_{c2}Li_{(1-c1-c2)})_{0.5}TiO_3$ where $0<c1<1$ and $0 \leq c2 \leq 1$ and $0 \leq c1+c2 \leq 1$, $Bi_{0.5}Ag_{0.5}ZrO_3$, $Bi_{0.5}(Na_{c1}K_{c2}Li_{(1-c1-c2)})_{0.5}HfO_3$ where $0 \leq c1 \leq 1$ and $0 \leq c2 \leq 1$ and $0 \leq c1+c2 \leq 1$, $Bi_{0.5}Ag_{0.5}HfO_3$, $BiScO_3$, $BiGaO_3$, and $BiFeO_3$, as a dopant.

**13.** The method of claim 10, wherein the KNN-based ceramic is represented by Formula 1 below:

<Formula 1>        $(1-a1-a2)(K_bNa_{(1-b)})NbO_3 - a1Bi_{0.5}(Na_{c1}K_{c2}Li_{(1-c1-c2)})_{0.5}ZrO_3 - a2BiScO_3$

where $0 \leq a1 \leq 1$, $0 \leq a2 \leq 1$, $0 \leq a1+a2 < 1$, $0<b<1$ $0 \leq c1 \leq 1$, $0 \leq c2 \leq 1$, $0 \leq c1+c2 \leq 1$.

**14.** The method of claim 10, wherein the BFO-based ceramic is represented by Formula 2 below:

<Formula 2>        $(1-d)BiFeO_3 - dBaTiO_3$

where $0 \leq d < 1$.

**Patentansprüche**

**1.** Gestapelte piezoelektrische Keramikstruktur, umfassend:

mindestens eine erste Schicht, umfassend eine K-Na-Nb-, KNN-basierte Keramik, und
mindestens eine zweite Schicht, umfassend eine Bi-Fe-O-, BFO-basierte Keramik,
wobei die erste Schicht und die zweite Schicht elektrisch parallel verbunden sind, und
wobei ein Verhältnis einer Anzahl $n_1$ der gestapelten ersten Schichten zu einer Anzahl $n_2$ der gestapelten zweiten Schichten in der gestapelten piezoelektrischen Keramikstruktur die nachstehende Gleichung (1) erfüllt:

$$0,8 \times |q|/|p| \leq n_1/n_2 \leq 1,2 \times |q|/|p| \ldots (1)$$

wobei

$|p|$ einen Absolutwert einer Abnahmerate p einer Ladungsempfindlichkeit abhängig von einer Temperatur der ersten Schicht darstellt, $|q|$ einen Absolutwert einer Steigerungsrate q einer Ladungsempfindlichkeit abhängig von einer Temperatur der zweiten Schicht darstellt, und
die Abnahmerate p der Ladungsempfindlichkeit abhängig von der Temperatur der ersten Schicht und die Steigerungsrate q der Ladungsempfindlichkeit abhängig von der Temperatur der zweiten Schicht Steigungswerte einer Geraden sind, die durch Annäherung der Ladungsempfindlichkeit abhängig von der Temperatur innerhalb eines Temperaturbereichs von Raumtemperatur 25 °C bis zu einer Curie-Temperatur, Tc, der KNN-basierten Keramik durch ein Verfahren der kleinsten Quadrate erlangt werden.

**2.** Gestapelte piezoelektrische Keramikstruktur nach Anspruch 1, wobei die KNN-basierte Keramik eine Keramik umfasst, die durch $(K_bNa_{(1-b)})NbO_3$ dargestellt ist, wobei $0<b<1$.

**3.** Gestapelte piezoelektrische Keramikstruktur nach Anspruch 2, wobei die KNN-basierte Keramik ferner mindestens ein Element umfasst, das ausgewählt ist aus der Gruppe, bestehend aus Li, Sb, Ta, $CaZrO_3$, $SrZrO_3$, $BaZrO_3$, $CaTiO_3$, $SrTiO_3$, $BaTiO_3$, $Bi_{0.5}(Na_{c1}K_{c2}Li_{(1-c1-c2)})_{0.5}ZrO_3$, wobei $0 \leq c1 \leq 1$ und $0 \leq c2 \leq 1$ und $0 \leq c1+c2 \leq 1$, $Bi_{0.5}(Na_{c1}K_{c2}Li_{(1-c1-c2)})_{0.5}TiO_3$, wobei $0 \leq c1 \leq 1$ und $0 \leq c2 \leq 1$ and $0 \leq c1+c2 \leq 1$, $Bi_{0.5}Ag_{0.5}ZrO_3$, $Bi_{0.5}(Na_{c1}K_{c2}Li_{(1-c1-c2)})_{0.5}HfO_3$, wobei $0 \leq c1 \leq 1$ und $0 \leq c2 \leq 1$ und $0 \leq c1+c2 \leq 1$, $Bi_{0.5}Ag_{0.5}HfO_3$, $BiScO_3$, $BiGaO_3$ und $BiFeO_3$ als Dotierstoff.

**4.** Gestapelte piezoelektrische Keramikstruktur nach Anspruch 1, wobei die KNN-basierte Keramik durch die nachstehende Formel 1 dargestellt ist:

<Formel I>    $(1-a1-a2)(K_bNa_{(1-b)})NbO_3 - a1Bi_{0,5}(Na_{c1}K_{c2}Li_{(1-c1-c2)})_{0,5}ZrO_3 - a2BiScO_3,$

wobei $0 \leq a1 \leq 1$, $0 \leq a2 \leq 1$, $0 \leq a1+a2 < 1$, $0 < b < 1$, $0 \leq c1 \leq 1$, $0 \leq c2 \leq 1$, $0 \leq c1+c2 \leq 1$.

5. Gestapelte piezoelektrische Keramikstruktur nach Anspruch 1, wobei die BFO-basierte Keramik durch die nachstehende Formel 2 dargestellt ist:

<Formel 2>    $(1-d)BiFeO_3 - dBaTiO_3$

wobei $0 \leq d < 1$.

6. Gestapelte piezoelektrische Keramikstruktur nach Anspruch 5, wobei d größer als oder gleich wie 0,2 und kleiner als oder gleich wie 0,4 ist.

7. Gestapelte piezoelektrische Keramikstruktur nach Anspruch 1, wobei die gestapelte piezoelektrische Keramikstruktur bleifrei ist.

8. Gestapelte piezoelektrische Keramikstruktur nach Anspruch 1, wobei der Absolutwert |p| der Abnahmerate p der Ladungsempfindlichkeit abhängig von der Temperatur der ersten Schicht 0,3 bis 0,4 pC/°Cg ist.

9. Gestapelte piezoelektrische Keramikstruktur nach Anspruch 1, wobei der Absolutwert |q| der Steigerungsrate q der Ladungsempfindlichkeit abhängig von der Temperatur der zweiten Schicht 0,15 bis 0,2 pC/°Cg ist.

10. Verfahren zur Herstellung einer gestapelten piezoelektrischen Keramikstruktur, umfassend:

Bilden eines Vorläuferpulvers einer K-Na-Nb-, KNN-basierten Keramik durch Kalzinieren eines KNN-basierten Vorläufergemischs, umfassend Natrium-Vorläuferpulver, Kalium-Vorläuferpulver und Niob-Vorläuferpulver;
Bilden eines Vorläuferpulvers einer Bi-Fe-O-, BFO-basierten Keramik durch Kalzinieren eines BFO-basierten Vorläufergemischs, umfassend Wismut-Vorläuferpulver, Eisen-Vorläuferpulver, Barium-Vorläuferpulver und Titan-Vorläuferpulver;
Bilden mindestens einer ersten Schicht durch Sintern des Vorläuferpulvers der KNN-basierten Keramik;
Bilden mindestens einer zweiten Schicht durch Sintern des Vorläuferpulvers der BFO-basierten Keramik; und
Bilden einer gestapelten Struktur, die $n_1$ der ersten Schichten und $n_2$ der zweiten Schichten beinhaltet,
wobei das Verhältnis einer Anzahl $n_1$ der gestapelten ersten Schichten zu einer Anzahl $n_2$ der gestapelten zweiten Schichten die nachstehende Gleichung (1) erfüllt:

$$0,8 \times |q|/|p| \leq n_1/n_2 \leq 1,2 \times |q|/|p| \ldots (1)$$

wobei

|p| einen Absolutwert einer Abnahmerate p einer Ladungsempfindlichkeit abhängig von einer Temperatur der ersten Schicht darstellt, |q| einen Absolutwert einer Steigerungsrate q einer Ladungsempfindlichkeit abhängig von einer Temperatur der zweiten Schicht darstellt, und
die Abnahmerate p der Ladungsempfindlichkeit abhängig von der Temperatur der ersten Schicht und die Steigerungsrate q der Ladungsempfindlichkeit abhängig von der Temperatur der zweiten Schicht Steigungswerte einer Geraden sind, die durch Annäherung der Ladungsempfindlichkeit abhängig von der Temperatur innerhalb eines Temperaturbereichs von Raumtemperatur 25 °C bis zu einer Curie-Temperatur, Tc, der KNN-basierten Keramik durch ein Verfahren der kleinsten Quadrate erlangt werden.

11. Verfahren nach Anspruch 10, wobei die KNN-basierte Keramik eine Keramik umfasst, die durch $(K_bNa_{(1-b)})NbO_3$ dargestellt ist, wobei $0 < b < 1$.

12. Verfahren nach Anspruch 11, wobei die KNN-basierte Keramik ferner mindestens ein Element umfasst, das ausgewählt ist aus der Gruppe, bestehend aus Li, Sb, Ta, $CaZrO_3$, $SrZrO_3$, $BaZrO_3$, $CaTiO_3$, $SrTiO_3$, $BaTiO_3$, $Bi_{0,5}(Na_{c1}K_{c2}Li_{(1-c1-c2)})_{0,5}ZrO_3$, wobei $0 \leq c1 \leq 1$ und $0 \leq c2 \leq 1$ und $0 \leq c1+c2 \leq 1$, $Bi_{0,5}(Na_{c1}K_{c2}Li_{(1-c1-c2)})_{0,5}TiO_3$, wobei $0 \leq c1 \leq 1$ und $0 \leq c2 \leq 1$ and $0 \leq c1+c2 \leq 1$, $Bi_{0,5}Ag_{0,5}ZrO_3$, $Bi_{0,5}(Na_{c1}K_{c2}Li_{(1-c1-c2)})_{0,5}HfO_3$, wobei $0 \leq c1 \leq 1$ und $0 \leq c2 \leq 1$ und $0 \leq c1+c2 \leq 1$, $Bi_{0,5}Ag_{0,5}HfO_3$, $BiScO_3$, $BiGaO_3$ und $BiFeO_3$ als Dotierstoff.

**13.** Verfahren nach Anspruch 10, wobei die KNN-basierte Keramik durch die nachstehende Formel 1 dargestellt ist:

<Formel I>   $(1-a1-a2)(K_bNa_{(1-b)})NbO_3 - a1Bi_{0,5}(Na_{c1}K_{c2}Li_{(1-c1-c2)})_{0,5}ZrO_3 - a2BiScO_3$,

wobei $0 \leq a1 \leq 1$, $0 \leq a2 \leq 1$, $0 \leq a1+a2 < 1$, $0 < b < 1$, $0 \leq c1 \leq 1$, $0 \leq c2 \leq 1$, $0 \leq c1+c2 \leq 1$.

**14.** Verfahren nach Anspruch 10, wobei die BFO-basierte Keramik durch die nachstehende Formel 2 dargestellt ist:

<Formel 2>   $(1-d)BiFeO_3 - dBaTiO_3$

wobei $0 \leq d < 1$.

**Revendications**

**1.** Structure empilée en céramique piézoélectrique, comprenant :

au moins une première couche comprenant une céramique à base de KNN, K-Na-Nb ; et
au moins une deuxième couche comprenant une céramique à base de BFO, Bi-Fe-O,
dans laquelle la première couche et la deuxième couche sont connectées électriquement en parallèle, et
dans laquelle un rapport d'un nombre $n_1$ des premières couches empilées sur un nombre $n_2$ des deuxièmes couches empilées dans la structure empilée en céramique piézoélectrique satisfait l'équation (1) ci-dessous :

$$0,8 \times |q|/|p| \leq n_1/n_2 \leq 1,2 \times |q|/|p| \qquad (1)$$

dans laquelle $|p|$ représente une valeur absolue d'un taux de diminution p d'une sensibilité de charge selon une température de la première couche, $|q|$ représente une valeur absolue d'un taux d'augmentation q d'une sensibilité de charge selon une température de la deuxième couche, et
le taux de diminution p de la sensibilité de charge selon la température de la première couche et le taux d'augmentation q de la sensibilité de charge selon la température de la deuxième couche sont des valeurs de pente d'une ligne droite obtenue en approximant la sensibilité de charge selon la température dans une plage de températures allant de la température ambiante, 25 °C, à une température de Curie, Tc, de la céramique à base de KNN par une méthode des moindres carrés.

**2. Structure** empilée en céramique piézoélectrique selon la revendication 1, dans laquelle la céramique à base de KNN comprend une céramique représenté par $(K_bNa_{(1-b)})NbO_3$ où $0 < b < 1$.

**3.** Structure empilée en céramique piézoélectrique selon la revendication 2, dans laquelle la céramique à base de KNN comprend en outre au moins l'un choisi dans le groupe consistant en Li, Sb, Ta, CaZrO_3, SrZrO_3, BaZrO_3, CaTiO_3, SrTiO_3, BaTiO_3, $Bi_{0,5}(Na_{c1}K_{c2}Li_{(1-c1-c2)})_{0,5}ZrO_3$, où $0 \leq c1 \leq 1$ et $0 \leq c2 \leq 1$ et $0 \leq c1+c2 \leq 1$, $Bi_{0,5}(Na_{c1}K_{c2}Li_{(1-c1-c2)})_{0,5}TiO_3$, où $0 \leq c1 \leq 1$ et $0 \leq c2 \leq 1$ et $0 \leq c1+c2 \leq 1$, $Bi_{0,5}Ag_{0,5}ZrO_3$, $Bi_{0,5}(Na_{c1}K_{c2}Li_{(1-c1-c2)})_{0,5}HfO_3$, où $0 \leq c1 \leq 1$ et $0 \leq c2 \leq 1$ et $0 \leq c1+c2 \leq 1$, $Bi_{0,5}Ag_{0,5}HfO_3$, $BiScO_3$, $BiGaO_3$ et $BiFeO_3$, comme dopant.

**4.** Structure empilée en céramique piézoélectrique selon la revendication 1, dans laquelle la céramique à base de KNN est représentée par la formule 1 ci-dessous :

<Formule 1>   $(1-a1-a2)(K_bNa_{(1-b)})NbO_3 - a1Bi_{0,5}(Na_{c1}K_{c2}Li_{(1-c1-c2)})_{0,5}ZrO_3 - a2BiScO_3$

où $0 \leq a1 \leq 1$, $0 \leq a2 \leq 1$, $0 \leq a1+a2 < 1$, $0 < b < 1$ $0 \leq c1 \leq 1$, $0 \leq c2 \leq 1$, $0 \leq c1+c2 \leq 1$.

**5.** Structure empilée en céramique piézoélectrique selon la revendication 1, dans laquelle la céramique à base de BFO est représentée par la formule 2 ci-dessous :

< Formule 2>   $(1-d)BiFeO_3 - dBaTiO_3$

où $0 \leq d < 1$.

**6.** Structure empilée en céramique piézoélectrique selon la revendication 5, dans laquelle d est supérieur ou égal à 0,2 et inférieur ou égal à 0,4.

**7.** Structure empilée en céramique piézoélectrique selon la revendication 1, dans laquelle la structure empilée en céramique piézoélectrique est exempte de plomb.

**8.** Structure empilée en céramique piézoélectrique selon la revendication 1, dans laquelle la valeur absolue |p| du taux de diminution p de la sensibilité de charge selon la température de la première couche est de 0,3 à 0,4 pC/°Cg.

**9.** Structure empilée en céramique piézoélectrique selon la revendication 1, dans laquelle la valeur absolue |q| du taux d'augmentation q de la sensibilité de charge selon la température de la deuxième couche est de 0,15 à 0,2 pC/°Cg.

**10.** Procédé de fabrication d'une structure empilée en céramique piézoélectrique, comprenant :

la formation d'une poudre précurseur d'une céramique à base de KNN, K-Na-Nb par calcination d'un mélange précurseur à base de KNN comprenant une poudre précurseur de sodium, une poudre précurseur de potassium et une poudre précurseur de niobium ;
la formation d'une poudre précurseur d'une céramique à base de BFO, Bi-Fe-O par calcination d'un mélange précurseur à base de BFO comprenant une poudre précurseur de bismuth, une poudre précurseur de fer, une poudre précurseur de baryum et une poudre précurseur de titane ;
la formation d'au moins une première couche par frittage de la poudre précurseur de la céramique à base de KNN ;
la formation d'au moins une deuxième couche par frittage de la poudre précurseur de la céramique à base de BFO ; et la formation d'une structure empilée incluant $n_1$ des premières couches et $n_2$ des deuxièmes couches, dans lequel un rapport d'un nombre $n_1$ des premières couches empilées sur un nombre $n_2$ des deuxièmes couches empilées satisfait l'équation (1) ci-dessous :

$$0,8 \times |q|/|p| \leq n_1/n_2 \leq 1,2 \times |q|/|p| \qquad (1)$$

**dans laquelle** |p| représente une valeur absolue d'un taux de diminution p d'une sensibilité de charge selon une température de la première couche, |q| représente une valeur absolue d'un taux d'augmentation q d'une sensibilité de charge selon une température de la deuxième couche, et
le taux de diminution p de la sensibilité de charge selon la température de la première couche et le taux d'augmentation q de la sensibilité de charge selon la température de la deuxième couche sont des valeurs de pente d'une ligne droite obtenue en approximant la sensibilité de charge selon la température dans une plage de températures allant de la température ambiante, 25 °C, à une température de Curie, Tc, de la céramique à base de KNN par une méthode des moindres carrés.

**11.** Procédé selon la revendication 10, dans lequel la céramique à base de KNN comprend une céramique représentée par $(K_bNa_{(1-b)})NbO_3$ où $0 < b < 1$.

**12.** Procédé selon la revendication 11, dans lequel la céramique à base de KNN comprend au moins l'un choisi dans le groupe consistant en Li, Sb, Ta, $CaZrO_3$, $SrZrO_3$, $BaZrO_3$, $CaTiO_3$, $SrTiO_3$, $BaTiO_3$, $Bi_{0,5}(Na_{c1}K_{c2}Li_{(1-c1-c2)})_{0,5}ZrO_3$, où $0 \leq c1 \leq 1$ et $0 \leq c2 \leq 1$ et $a \leq c1+c2 \leq 1$, $Bi_{0,5}(Na_{c1}K_{c2}Li_{(1-c1-c2)})_{0,5}TiO_3$, où $a \leq c1 \leq 1$ et $a \leq c2 \leq 1$ et $a \leq c1+c2 \leq 1$, $Bi_{0,5}Ag_{0,5}ZrO_3$, $Bi_{0,5}(Na_{c1}K_{c2}Li_{(1-c1-c2)})_{0,5}HfO_3$, Où $0 \leq c1 \leq 1$ et $0 \leq c2 \leq 1$ et $0 \leq c1+c2 \leq 1$, $Bi_{0,5}Ag_{0,5}HfO_3$, $BiScO_3$, $BiGaO_3$ et $BiFeO_3$, comme dopant.

**13.** Procédé selon la revendication 10, dans lequel la céramique à base de KNN est représentée par la formule 1 ci-dessous :

<Formule 1>  $(1-a1-a2)(K_bNa_{(1-b)}NbO_3 - a1Bi_{0,5}(Na_{c1}K_{c2}Li_{(1-c1-c2)})_{0,5}ZrO_3 - a2BiScO_3$

où $0 \leq a1 \leq 1$, $0 \leq a2 \leq 1$, $0 \leq a1 +a2 < 1$, $a < b < 1$, $0 \leq c1 \leq 1$, $0 \leq c2 \leq 1,0 \leq c1+c2 \leq 1$.

**14.** Procédé selon la revendication 10, dans lequel la céramique à base de BFO est représentée par la formule 2 ci-dessous :

< Formule 2>    $(1-d)BiFeO_3 - dBaTiO_3$

où $0 \leq d < 1$.

【FIG. 1】

screw

mass body

electrode
piezoelectric ceramic
Insulator
base

[Fig. 2]

【FIG. 3】

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220153850
- EP 3413362 A
- US 2020096533 A

**Non-patent literature cited in the description**

- **ZUO et al.** *Journal of Physics and Chemistry of Solids*, 2008, vol. 69, 230-235
- **AIZHEN et al.** *Advance Functional Materials*, 2022
- **MIN-KU et al.** *JOURNAL OF THE EUROPEAN CERAMIC SOCIETY*, 2022, vol. 42 (12), 4898-4906